# EUROPEAN PATENT APPLICATION

(11) **EP 4 693 371 A1**
(43) Date of publication of application: **11.02.2026**
(21) Application number: 23930287.0
(22) Date of filing: 27.03.2023
(51) Int. Cl.: H01L 21/205

(54) **SUBSTRATE PROCESSING METHOD, METHOD FOR PRODUCING SEMICONDUCTOR DEVICE, PROGRAM, AND SUBSTRATE PROCESSING APPARATUS**

(71) Applicant: Kokusai Electric Corporation, Tokyo 101-0045 (JP)
(72) Inventor: KURIBAYASHI, Koei, Toyama-shi, Toyama 939-2393 (JP); KAGA, Yukinao, Toyama-shi, Toyama 939-2393 (JP)
(74) Representative: Verscht, Thomas Kurt Albert
(86) International application number: PCT/JP2023/012155
(87) International publication number: WO 2024/201647

(57) **Abstract**

Provided is a technique whereby it is possible to improve the characteristics of a film to be formed on a substrate. This method includes: (a) a step of depositing a film by supplying a first raw material gas and a reaction gas to the substrate; and (b) a step of etching the substrate by supplying a second raw material gas and the reaction gas to the substrate after (a).

## Description

### [Technical Field]

The present disclosure relates to a substrate processing method, a method of manufacturing a semiconductor device, a program and a substrate processing apparatus.

### [Related Art]

As a part of a manufacturing process of a semiconductor device, a process of forming a metal film on a substrate may be performed (for example, see Patent Document 1).

### [Related Art Document]

### [Patent Document]

Patent Document 1: Japanese Patent Laid-Open No. 2021-120472

### [Disclosure]

### [Technical Problem]

When the film is selectively formed on the substrate, there may occur a case where selectivity is impaired to cause variations in characteristics of the film formed on the substrate.

According to the present disclosure, there is provided a technique capable of improving characteristics of the film formed on the substrate.

### [Technical Solution]

According to an embodiment of the present disclosure, there is provided a technique that includes: (a) forming a film by supplying a first source gas and a reactive gas to a substrate; and (b) etching the substrate by supplying a second source gas and the reactive gas to the substrate after (a).

### [Advantageous Effects]

According to some embodiments of the present disclosure, it is possible to improve characteristics of a film formed on a substrate.

### [Brief Description of Drawings]

FIG. 1 is a diagram schematically illustrating a vertical cross-section of a vertical type process furnace of a substrate processing apparatus according to embodiments of the present disclosure.
FIG. 2 is a diagram schematically illustrating a horizontal cross-section taken along a line A - A shown in FIG. 1.
FIG. 3 is a block diagram schematically illustrating a configuration of a controller and its related components of the substrate processing apparatus according to the embodiments of the present disclosure.
FIG. 4 is a diagram schematically illustrating a substrate processing according to the embodiments of the present disclosure.
FIGS. 5(A) to 5(D) are diagrams schematically illustrating cross-sections for explaining states on a substrate in the substrate processing according to the embodiments of the present disclosure, respectively.
FIG. 6 is a diagram schematically illustrating a modified example of the substrate processing according to the embodiments of the present disclosure.
FIGS. 7(A) to 7(F) are diagrams schematically illustrating modified examples of a film forming step according to the embodiments of the present disclosure, respectively.
FIGS. 8(A) to 8(F) are diagrams schematically illustrating modified examples of an etching step according to the embodiments of the present disclosure, respectively.
FIG. 9 is a diagram schematically illustrating another modified example of the substrate processing according to the embodiments of the present disclosure.
FIG. 10 is a diagram schematically illustrating a modified example of the substrate processing apparatus according to the embodiments of the present disclosure.

### DETAILED DESCRIPTION

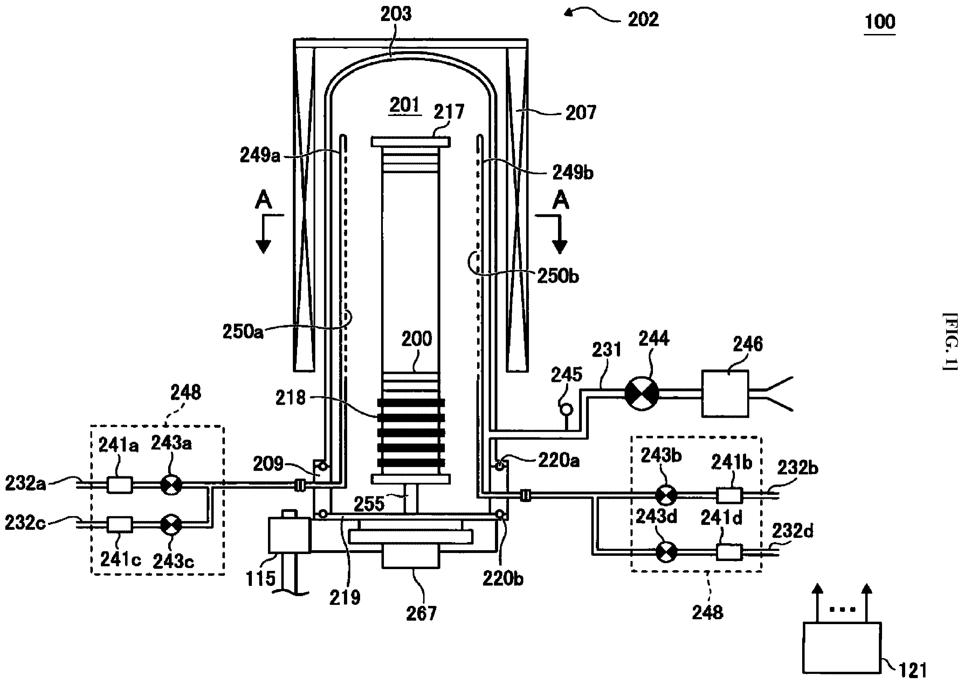

Hereinafter, embodiments of the technique of the present disclosure will be described in detail mainly with reference to FIGS. 1 to 5. In addition, the drawings used in the following descriptions are all schematic. For example, a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

As shown in FIG. 1, a process furnace 202 includes a heater 207 serving as a heating system (which is a temperature regulator). The heater 207 is of a cylindrical shape. The heater 207 also functions as an activator (also referred to as an "exciter") capable of activating (or exciting) a gas by a heat.

A reaction tube 203 is provided in an inner side of the heater 207 to be aligned in a manner concentric with the heater 207. For example, the reaction tube 203 is made of a heat resistant material such as quartz (SiO₂) and silicon carbide (SiC). For example, the reaction tube 203 is of a cylindrical shape with a closed upper end and an open lower end. A manifold 209 is provided under the reaction tube 203 to be aligned in a manner concentric with the reaction tube 203. For example, the manifold 209 is made of a metal material such as stainless steel (SUS). For example, the manifold 209 is of a cylindrical shape with open upper and lower ends. An upper end portion of the manifold 209 is engaged with a lower end portion of the reaction tube 203 so as to support the reaction tube 203. An O-ring 220a serving as a seal is provided between the manifold 209 and the reaction tube 203. Similar to the heater 207, the reaction tube 203 is installed vertically. A process vessel (also referred to as a "reaction vessel") is constituted mainly by the reaction tube 203 and the manifold 209. A process chamber 201 is provided in a hollow cylindrical portion of the process vessel. The process chamber 201 is configured to be capable of accommodating a plurality of wafers 200 serving as substrates.

Nozzles 249a and 249b are provided in the process chamber 201 so as to penetrate a side wall of the manifold 209. Gas supply pipes (piping) 232a and 232b are connected to the nozzles 249a and 249b, respectively.

Mass flow controllers (MFCs) 241a and 241b serving as flow rate controllers (flow rate control structures) and valves 243a and 243b serving as opening/closing valves are sequentially installed at the gas supply pipes 232a and 232b, respectively, in this order from upstream sides to downstream sides of the gas supply pipes 232a and 232b. Gas supply pipes 232c and 232d through which inert gas is supplied are connected to the gas supply pipes 232a and 232b, respectively, at downstream sides of the valves 243a and 243b. MFCs 241c and 241d and valves 243c and 243d are sequentially installed at the gas supply pipes 232c and 232d, respectively, in this order from upstream sides to downstream sides of the gas supply pipes 232c and 232d.

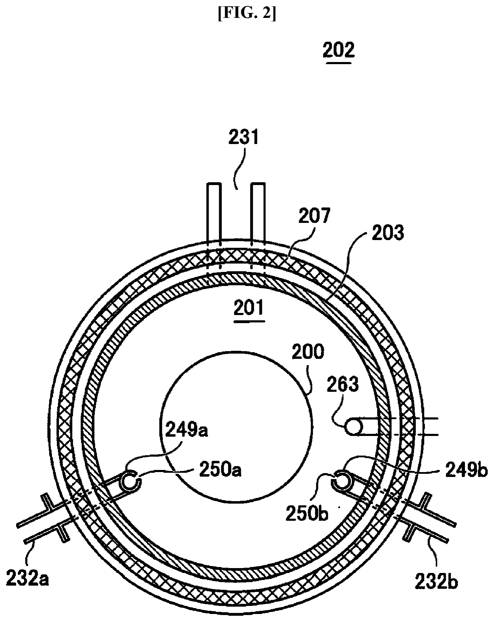

As shown in FIG. 2, each of the nozzles 249a and 249b is installed in an annular space provided between an inner wall of the reaction tube 203 and the wafers 200 when viewed from above, and extends upward from a lower portion toward an upper portion of the reaction tube 203 along the inner wall of the reaction tube 203 (that is, extends upward along an arrangement direction of the wafers 200). A plurality of gas supply holes 250a and a plurality of gas supply holes 250b are provided at side surfaces of the nozzles 249a and 249b, respectively. Gases are supplied via the gas supply holes 250a and the gas supply holes 250b, respectively. The gas supply holes 250a and the gas supply holes 250b are open to face a center of the reaction tube 203, and are configured such that the gases are supplied toward the wafers 200 via the gas supply holes 250a and the gas supply holes 250b, respectively. The gas supply holes 250a and the gas supply holes 250b are provided from the lower portion toward the upper portion of the reaction tube 203.

A source gas containing a halogen element is supplied into the process chamber 201 through the gas supply pipe 232a provided with the MFC 241a and the valve 243a and the nozzle 249a.

A reactive gas reacting with the source gas is supplied into the process chamber 201 through the gas supply pipe 232b provided with the MFC 241b and the valve 243b and the nozzle 249b. As the reactive gas, a reducing gas may be used.

The inert gas is supplied into the process chamber 201 through the gas supply pipes 232c and 232d provided with the MFCs 241c and 241d and the valves 243c and 243d, respectively, the gas supply pipe 232a, the gas supply pipe 232b, the nozzle 249a and the nozzle 249b.

A source gas supplier (which is a source gas supply system) is constituted mainly by the gas supply pipe 232a, the MFC 241a and the valve 243a. A reactive gas supplier (which is a reactive gas supply system) is constituted mainly by the gas supply pipe 232b, the MFC 241b and the valve 243b. The source gas supplier and the reactive gas supplier may also be collectively or individually referred to as a gas supplier (which is a gas supply system). In addition, an inert gas supplier (which is an inert gas supply system) is constituted mainly by the gas supply pipes 232c and 232d, the MFCs 241c and 241d and the valves 243c and 243d. The gas supplier may further include the inert gas supplier. The reactive gas supplier may also be referred to as a "reducing gas supplier" which is a reducing gas supply system.

Any one or an entirety of the suppliers described above may be configured as an integrated gas supply system 248 in which the components such as the valves 243a to 243d and the MFCs 241a to 241d are integrated. The integrated gas supply system 248 is connected to each of the gas supply pipes 232a to 232d. Operations of the integrated gas supply system 248 to supply various gases to the gas supply pipes 232a to 232d, for example, operations such as opening and closing operations of the valves 243a to 243d and flow rate adjusting operations for the gases by the MFCs 241a to 241d may be controlled by a controller 121 described later. The integrated gas supply system 248 may be embodied as an integrated structure (integrated unit) of an all-in-one type or a divided type. The integrated gas supply system 248 may be attached to or detached from the components such as the gas supply pipes 232a to 232d on a basis of the integrated structure. Operations such as maintenance, replacement and addition for the integrated gas supply system 248 may be performed on a basis of the integrated structure.

An exhaust pipe 231 through which an atmosphere (inner atmosphere) of the process chamber 201 is exhausted is connected to the reaction tube 203. A vacuum pump 246 serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect a pressure (inner pressure) of the process chamber 201, and the APC valve 244 serves as a pressure regulator (pressure adjusting structure). With the vacuum pump 246 in operation, the APC valve 244 can be opened or closed to perform a vacuum exhaust operation for the process chamber 201 or stop the vacuum exhaust operation. In addition, with the vacuum pump 246 in operation, the inner pressure of the process chamber 201 can be adjusted by adjusting an opening degree of the APC valve 244 based on pressure information detected by the pressure sensor 245. An exhauster (which is an exhaust system) is constituted mainly by the exhaust pipe 231, the APC valve 244 and the pressure sensor 245. The exhauster may further include the vacuum pump 246.

A seal cap 219 serving as a furnace opening lid capable of airtightly sealing (or closing) a lower end opening of the manifold 209 is provided below the manifold 209. For example, the seal cap 219 is made of a metal material such as stainless steel (SUS), and is of a disk shape. An O-ring 220b serving as a seal is provided on an upper surface of the seal cap 219 so as to be in contact with the lower end of the manifold 209. A rotator (which is a rotating structure) 267 configured to rotate a boat 217 described later is provided under the seal cap 219. A rotating shaft 255 of the rotator 267 is connected to the boat 217 through the seal cap 219. The rotator 267 is configured to rotate the wafers 200 by rotating the boat 217. The seal cap 219 is configured to be elevated or lowered in a vertical direction by a boat elevator 115 serving as an elevating structure provided outside the reaction tube 203. The boat elevator 115 is configured to be capable of transferring (loading) the boat 217 into the process chamber 201 and capable of transferring (unloading) the boat 217 out of the process chamber 201 by elevating and lowering the seal cap 219. The boat elevator 115 serves as a transfer apparatus (which is a transfer structure) capable of loading the boat 217 (that is, the wafers 200) into the process chamber 201 and unloading the boat 217 (that is, the wafers 200) out of the process chamber 201.

The boat 217 (which serves as a substrate support) is configured such that the wafers 200 (for example, from 25 wafers to 200 wafers) are accommodated (or supported) in the vertical direction in the boat 217 while the wafers 200 are horizontally oriented with their centers aligned with one another in a multistage manner. That is, the boat 217 is configured such that the wafers 200 are arranged in the vertical direction in the boat 217 with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner. In addition, in the present specification, a notation of a numerical range such as "from 25 wafers to 200 wafers" means that a lower limit and an upper limit are included in the numerical range. Therefore, for example, a numerical range "from 25 wafers to 200 wafers" means a range equal to or higher than 25 wafers and equal to or less than 200 wafers. The same also applies to other numerical ranges described in the present specification.

A temperature sensor 263 serving as a temperature detector is installed in the reaction tube 203. A state of electric conduction to the heater 207 is adjusted based on temperature information detected by the temperature sensor 263 such that a desired temperature distribution of a temperature (inner temperature) of the process chamber 201 can be obtained. The temperature sensor 263 is L-shaped, and is provided along the inner wall of the reaction tube 203.

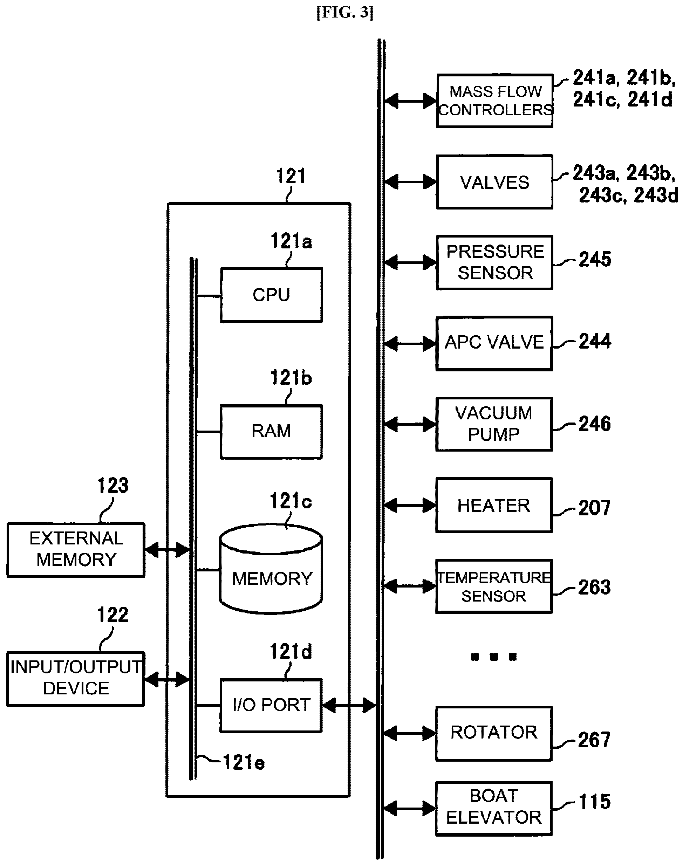

As shown in FIG. 3, the controller 121 serving as a control structure (control apparatus) is constituted by a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the controller 121. For example, as the control structure, the substrate processing apparatus may include a single control structure, or may include a plurality of control structures. That is, a control operation of performing a process sequence described later may be performed using the single control structure, or may be performed using the plurality of control structures. In addition, the plurality of control structures may be configured as a control system that are connected to one another via a wired or wireless communication network, and an entirety of the control system may perform the control operation of performing the process sequence described later. Thus, in the present specification, the term "control structure" may refer to the single control structure, may refer to the plurality of control structures, or may refer to the control system configured by the plurality of control structures.

For example, the memory 121c is configured by a component such as a flash memory and a hard disk drive (HDD). For example, a control program configured to control an operation of the substrate processing apparatus 100 and a process recipe containing information on procedures and conditions of a substrate processing described later may be readably stored in the memory 121c. The process recipe is obtained by combining steps (procedures) of the substrate processing described later such that the controller 121 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241d, the valves 243a to 243d, the pressure sensor 245, the APC valve 244, the vacuum pump 246, the heater 207, the temperature sensor 263, the rotator 267 and the boat elevator 115.

The CPU 121a is configured to read the control program from the memory 121c and execute the control program read from the memory 121c. In addition, the CPU 121a is configured to read the recipe from the memory 121c, for example, in accordance with an operation command inputted from the input/output device 122. In accordance with contents of the recipe read from the memory 121c, the CPU 121a may be configured to control various operations such as the flow rate adjusting operations for various gases by the MFCs 241a to 241d, the opening and closing operations of the valves 243a to 243d, an opening and closing operation of the APC valve 244, a pressure regulating operation (pressure adjusting operation) by the APC valve 244 based on the pressure sensor 245, a start and stop operation of the vacuum pump 246, a temperature regulating operation (temperature adjusting operation) by the heater 207 based on the temperature sensor 263, an operation of adjusting a rotation and a rotation speed of the boat 217 by the rotator 267 and an elevating and lowering operation of the boat 217 by the boat elevator 115.

The controller 121 may be embodied by installing the above-described program stored in an external memory 123 into the computer. For example, the external memory 123 may include a magnetic disk such as a hard disk, an optical disk such as a CD, a magneto-optical disk such as an MO and a semiconductor memory such as a USB memory. The memory 121c or the external memory 123 may be embodied by a non-transitory computer readable recording medium storing a program. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. For example, instead of the external memory 123, a communication interface such as the Internet and a dedicated line may be used for providing the program to the computer.

### (2) Substrate Processing

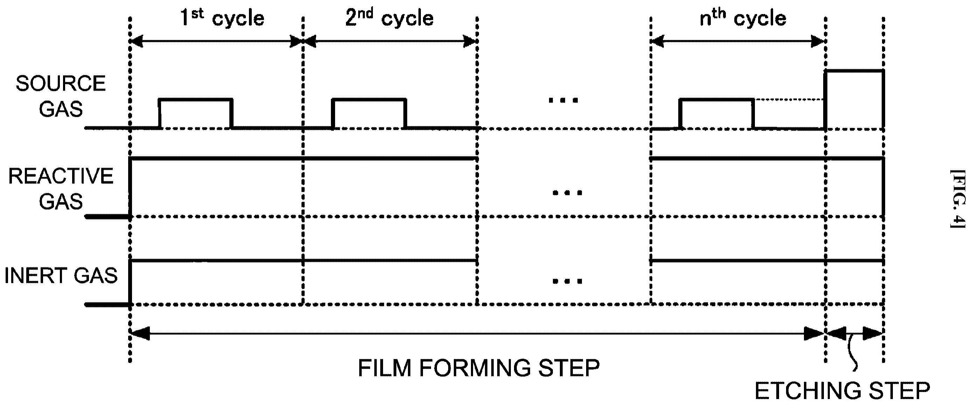

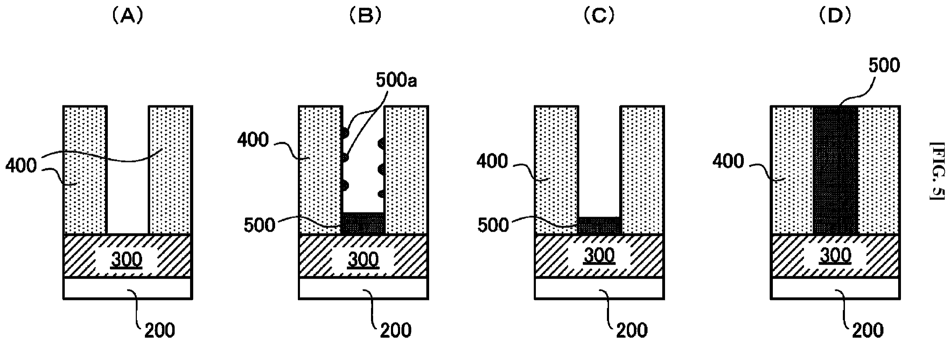

Hereinafter, an example of the process sequence of forming a predetermined film in a recess on the wafer 200, which is a part of the substrate processing in a manufacturing process of a semiconductor device performed by using the substrate processing apparatus 100 described above, will be described with reference to FIGS. 4 and 5. In the following description, operations of components constituting the substrate processing apparatus 100 are controlled by the controller 121. In FIG. 4, a horizontal axis indicates a time, and a vertical axis indicates a flow rate of each gas or a value of a partial pressure of each gas. The same also applies to the following description.

In the present specification, the term "wafer" may refer to "a wafer itself', or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

### <Wafer Loading Step>

The wafers 200 are charged (transferred) into the boat 217 (wafer charging step). Then, as shown in FIG. 1, the boat 217 supporting the wafers 200 is elevated by the boat elevator 115 and thereby loaded (transferred) into the process chamber 201 and accommodated in the process vessel (boat loading step). In such a state, the seal cap 219 airtightly seals the lower end opening of the manifold 209 via the O-ring 220b.

### <Pressure Adjusting Step and Temperature Adjusting Step>

Then, the vacuum pump 246 vacuum-exhausts the inner atmosphere of the process chamber 201 (that is, a space in which the wafers 200 are present (accommodated)) such that the inner pressure of the process chamber 201 reaches and is maintained at a desired pressure (vacuum level). At this time, the inner pressure of the process chamber 201 is measured by the pressure sensor 245, and the APC valve 244 is feedback-controlled based on the pressure information detected by the pressure sensor 245 (pressure adjusting step). The vacuum pump 246 continuously vacuum-exhausts the inner atmosphere of the process chamber 201 until at least a processing of the wafer 200 is completed. In addition, the heater 207 heats the process chamber 201 such that a temperature of the wafer 200 in the process chamber 201 reaches and is maintained at a desired temperature. At this time, the state of the electric conduction to the heater 207 is feedback-controlled based on the temperature information detected by the temperature sensor 263 such that a desired temperature distribution of the inner temperature of the process chamber 201 can be obtained (temperature adjusting step). The heater 207 continuously heats the process chamber 201 until at least the processing of the wafer 200 is completed.

In the present embodiments, by using a substance (material) described in the present disclosure as the source gas, it is possible to etch the film formed on the wafer 200 or to etch at least a part of the wafer 200 itself. Such an etching may be caused by characteristics of the source gas itself, by-products generated from the source gas or by-products generated by a reaction between the source gas and the reactive gas. Further, the film may be formed on the wafer 200 by a self-reaction (for example, a decomposition reaction) or the reaction between the source gas and the reactive gas. In the present disclosure, it is possible to control a balance between a film forming amount and an etching amount on the wafer 200 by supply conditions of the source gas and the reactive gas. In other words, both a film formation and the etching may occur in a step of supplying the source gas and/or the reactive gas of the present disclosure. In the following, the description will be provided as to a processing in which the film formation prevails as a film forming step where the film forming amount is greater than the etching amount and a processing in which the etching prevails where the etching amount is greater than the film forming amount.

### <Film Forming Step>

### <Reactive Gas Supply Step S1>

First, the reactive gas is supplied to the wafer 200 in the process chamber 201 and exhausted. Specifically, the valve 243b is opened to supply the reactive gas into the gas supply pipe 232b. After a flow rate of the reactive gas is adjusted by the MFC 241b, the reactive gas whose flow rate is adjusted is supplied into the process chamber 201 through the nozzle 249b, and is exhausted through the exhaust pipe 231. At this time, in parallel with a supply of the reactive gas, the valve 243d is opened to supply the inert gas into the gas supply pipe 232d. After a flow rate of the inert gas is adjusted by the MFC 241d, the inert gas whose flow rate is adjusted is supplied into the process chamber 201 together with the reactive gas, and is exhausted through the exhaust pipe 231. In addition, in order to prevent the reactive gas from entering the nozzle 249a, the valve 243c is opened to supply the inert gas into the gas supply pipe 232c. The inert gas is supplied into the process chamber 201 through the gas supply pipe 232c and the nozzle 249a, and is exhausted through the exhaust pipe 231.

At this time, a main gas flowing in the process chamber 201 is the reactive gas. That is, the reactive gas is supplied to the wafer 200.

As the reactive gas, the reducing gas may be used. As the reducing gas, for example, a gas containing hydrogen element (H) may be used. As the gas containing hydrogen element, a gas such as hydrogen (H₂) gas, monosilane (SiH₄) gas, disilane (Si₂H₆) gas, trisilane (Sl₃H₈) gas, ammonia (NH₃) gas, hydrazine (N₂H₄) gas and phosphine (PH₃) gas may be used. As the reactive gas, one or more of the gases exemplified above may be used.

As the inert gas, for example, instead of or in addition to the nitrogen (N₂) gas, a rare gas such as argon (Ar) gas, helium (He) gas, neon (Ne) gas and xenon (Xe) gas may be used. As the inert gas, one or more of the gases exemplified above may be used.

### <Step of Simultaneously Supplying Source Gas and Reactive Gas, Step S2>

After a predetermined time has elapsed from a start of the step S1, while the reactive gas is being supplied to the wafer 200 in the process chamber 201, a supply of the source gas serving as a first source gas is started. Specifically, with the valve 243b open, the valve 243a is opened to supply the source gas into the gas supply pipe 232a. After a flow rate of the source gas is adjusted by the MFC 241a, the source gas whose flow rate is adjusted is supplied into the process chamber 201 through the nozzle 249a, and is exhausted through the exhaust pipe 231. At this time, in parallel with the supply of the source gas, the valve 243c is opened to supply the inert gas into the gas supply pipe 232c. After a flow rate of the inert gas is adjusted by the MFC 241c, the inert gas whose flow rate is adjusted is supplied into the process chamber 201 together with the source gas, and is exhausted through the exhaust pipe 231.

At this time, a main gas flowing in the process chamber 201 is the source gas and the reactive gas. That is, the source gas and the reactive gas are simultaneously supplied to the wafer 200.

At this time, while maintaining a partial pressure of the reactive gas from the step S1, the source gas and the reactive gas are supplied such that a partial pressure of the source gas is set to be lower than the partial pressure of the reactive gas. That is, the source gas and the reactive gas are supplied such that a supply amount of the source gas is set to be smaller than a supply amount of the reactive gas. By performing a CVD (Chemical Vapor Deposition) process in a manner described above, the film forming amount by the source gas and the reactive gas can be set to be larger than the etching amount by the source gas and the reactive gas, and the film formation prevails. Therefore, in the present step, by supplying the source gas and the reactive gas under conditions where the film formation prevails, it is possible to perform the film formation on the wafer 200 to form a first layer. That is, a gas phase reaction occurs, and the source gas is reduced by the reactive gas. Thereby, the first layer is formed on the wafer 200. In addition, by simultaneously supplying the source gas and the reactive gas, it is possible to improve a film forming rate. In addition, in the present disclosure, the "supply amount" means one or more among gas supply parameters such as a supply time, a supply flow rate, the inner pressure of the process chamber 201 when the gas is supplied, a pressure (inner pressure) of the gas supply pipe related thereto, a partial pressure of the gas related thereto, the number of times of supplying the gas related thereto and the number of pulses. In addition, the "supply amount" may mean two or more parameters, for example, a product of the supply time and the supply flow rate. In addition, the supply amount may also be referred to as an "amount of gas molecules" present in the process chamber 201.

As the source gas, a gas containing a halogen element may be used. As the gas containing the halogen element, for example, a gas containing an element such as fluorine (F), chlorine (Cl), bromine (Br) and iodine (I) may be used. As the source gas, one or more of the gases exemplified above may be used.

In addition, as the source gas, a gas containing the halogen element and a metal element may be used. In the present embodiments, as the metal element, a transition metal from the Group 3 to the Group 12, a Group 13 element (for example, aluminum (Al), gallium (Ga) and indium (In)), or silicon (Si) may be used.

That is, as the source gas, the gas containing the halogen element and the metal element may be used. As the metal element, a Group 4 element such as titanium (Ti), zirconium (Zr) and hafnium (Hf), the Group 13 element, or the element described in the present disclosure may be used. As such a gas, for example, a gas such as the gases described in the present disclosure, titanium tetrachloride (TiCl₄) gas, aluminum chloride (AlCl₃) gas, hafnium chloride (HfCl₄) gas and zirconium chloride (ZrCl₄) gas may be used. As the source gas, one or more of the gases exemplified above may be used. As the source gas, preferably, the gas containing the halogen element and the transition metal may be used.

In addition, as a gas containing the transition metal, for example, a gas containing a Group 6 element such as chromium (Cr), molybdenum (Mo) and tungsten (W) may be used. As a gas containing the halogen element and the group 6 element, for example, a gas such as tungsten hexafluoride (WF₆) gas, tungsten hexachloride (WCl₆) gas, molybdenum pentachloride (MoCl₅) gas, molybdenum dichloride dioxide (MoO₂Cl₂) gas, molybdenum tetrachloride oxide (MoOCl₄) gas, molybdenum hexafluoride (MoF₆) gas, molybdenum difluoride dioxide (MoO₂F₂) gas and molybdenum tetrafluoride oxide (MoOF₄) gas may be used. As the source gas, one or more of the gases exemplified above may be used.

In addition, as the source gas, instead of or in addition to the gas containing the halogen element and the transition metal, a gas containing the halogen element and silicon may be used. As the gas containing the halogen element and silicon, for example, a gas such as silicon tetrachloride (SiCl₄) gas, dichlorosilane (SiH₂Cl₂, abbreviated as DCS) gas and hexachlorodisilane (Si₂Cl₆, abbreviated as HCDS) gas may be used. As the source gas, one or more of the gases exemplified above may be used.

When, for example, the MoCl₅ gas is used as the source gas and, for example, the H₂ gas is used as the reactive gas, the MoCl₅ gas and the H₂ gas react with each other, so that chlorine (Cl) in the MoCl₅ gas is reduced by the H₂ gas, and a molybdenum (Mo)-containing layer serving as a metal-containing layer is formed as the first layer on the wafer 200. The molybdenum-containing layer may be a molybdenum layer containing chlorine, may be an adsorption layer of MoCl₅, or may be both of the molybdenum layer containing chlorine and the adsorption layer of MoCl₅. At this time, reaction by-products such as hydrogen chloride (HCl) and Cl₂ are generated. However, the MoCl₅ gas and the H₂ gas are supplied under conditions where the film formation prevails such that a film forming amount by the MoCl₅ gas and the H₂ gas can be set to be larger than an etching amount by the MoCl₅ gas and the H₂ gas. Therefore, the molybdenum-containing layer is formed on the wafer 200.

### <Reactive Gas Supply Step S3>

After a predetermined time has elapsed from a start of the step S2, while the reactive gas is being supplied to the wafer 200, the supply of the source gas into the process chamber 201 is stopped. Specifically, the valve 243a is closed to stop the supply of the source gas into the process chamber 201. At this time, in order to prevent the reactive gas from entering the nozzle 249a, the valve 243c is opened to supply the inert gas into the gas supply pipe 232c. The inert gas is supplied into the process chamber 201 through the gas supply pipe 232c and the nozzle 249a, and is exhausted through the exhaust pipe 231.

At this time, a main gas flowing in the process chamber 201 is the reactive gas. That is, the reactive gas is continuously supplied to the wafers 200 before and after the supply of the source gas. In other words, in the present step, there is a time during which the source gas is supplied while the reactive gas is being supplied.

In addition, after a simultaneous supply of the source gas and the reactive gas in the step S2 described above and before a simultaneous supply of the source gas and the reactive gas in a step S5 described later, in other words, between the simultaneous supply of the source gas and the reactive gas in the step S2 described above and the simultaneous supply of the source gas and the reactive gas in the step S5 described later, the reactive gas is continuously supplied without supplying the source gas. By continuously supplying the reactive gas in a manner described above, it is possible to remove (purge) the reaction by-products generated by the supply of the source gas and the supply of the reactive gas from the process chamber 201, and it is also possible to prevent (or suppress) the reaction by-products remaining in the process chamber 201 from being adsorbed on the wafer 200. In addition, by continuously supplying the reactive gas, it is possible to react the source gas (which is unreacted) with the reactive gas.

### <Performing Predetermined Number of Times, Step S4>

By performing a cycle (wherein the steps S1 to S3 described above are performed sequentially) a predetermined number of times (n times, wherein n is an integer of 1 or 2 or more), it is possible to form a film of a predetermined thickness on the wafer 200. Specifically, a metal-containing film such as a molybdenum-containing film is formed. When the number of executions of the cycle of performing the steps S1 to S3 sequentially is less than the predetermined number of times, the step S1 is performed again. In FIG. 4, a case where n is 3 or more is shown. However, n may be 1 or more.

That is, as described above, during the cycle of the film forming step, there is a period (time duration) during which a period in which the source gas is supplied and a period in which the reactive gas is supplied overlap. In addition, during the cycle of the film forming step, a supply time of the reactive gas after the supply of the source gas is completed is set to be longer than a supply time of the reactive gas before the supply of the source gas is started. Thereby, it is possible to improve an efficiency of removing the reaction by-products. In addition, a supply time of the reactive gas after the supply of the source gas is started is set to be longer than the supply time of the reactive gas before the supply of the source gas is started. Thereby, it is possible to react the source gas (which is unreacted) with the reactive gas. As a result, it is possible to improve the film forming rate.

In the present embodiments, a case where, for example, a metal-containing film 500 is formed in the recess will be described as an example. As shown in FIG. 5(A), a metal-containing film 300 serving as a conductive film is exposed on a bottom surface of the wafer 200, and a dielectric film (insulating film) 400 is exposed on a side wall surface of the recess.

When the cycle of performing the steps S1 to S3 sequentially as mentioned above is preformed the predetermined number of times, as shown in FIG. 5(B), there may occur a case where selectivity is impaired not only on the metal-containing film 300 in the recess but also on the dielectric film 400 (which serves as the side wall surface of the recess) so that a nucleus 500a may be formed. When the nucleus 500a grows, the metal-containing film 500 is not formed uniformly in the recess, and a seam or a void may occur in the metal-containing film 500 in the recess. Thereby, it may not be possible to obtain desired characteristics of the film.

According to the embodiments of the present disclosure, after the cycle of performing the steps S1 to S3 sequentially as mentioned above is preformed the predetermined number of times (n times, wherein n is an integer of 1 or 2 or more), the etching step of removing the nucleus 500a formed on the side wall surface in the recess and the like is performed as shown in FIG. 5(C) at a timing the nucleus 500a is formed.

### <Etching Step>

### <Step of Simultaneously Supplying Source Gas and Reactive Gas, Step S5>

After the cycle of performing the steps S1 to S3 sequentially as mentioned above is preformed the predetermined number of times, while the reactive gas is being continuously supplied into the process chamber 201, a supply of the source gas serving as a second source gas is started. Specifically, with the valve 243b open, the valve 243a is opened to supply the source gas into the gas supply pipe 232a. After the flow rate of the source gas is adjusted by the MFC 241a, the source gas whose flow rate is adjusted is supplied into the process chamber 201 through the nozzle 249a, and is exhausted through the exhaust pipe 231. At this time, in parallel with the supply of the source gas, the valve 243c is opened to supply the inert gas into the gas supply pipe 232c. After the flow rate of the inert gas is adjusted by the MFC 241c, the inert gas whose flow rate is adjusted is supplied into the process chamber 201 together with the source gas, and is exhausted through the exhaust pipe 231.

At this time, a main gas flowing in the process chamber 201 is the source gas and the reactive gas. That is, the source gas and the reactive gas are simultaneously supplied to the wafer 200. According to the present embodiments, the same source gas as that used in the step S2 of the film forming step described above is used in the present step. In addition, the same reactive gas as that used in the step S2 of the film forming step described above is used in the present step.

At this time, while maintaining the partial pressure of the reactive gas from the step S1, the partial pressure of the source gas is set to be different from the partial pressure of the source gas in the step S2 described above. Specifically, the source gas and the reactive gas are supplied such that the partial pressure of the source gas in the present step is set to be higher than the partial pressure of the source gas in the step S2. That is, the flow rate of the source gas in the present step is set to be higher than the flow rate of the source gas in the step S2. In other words, in the etching step, the source gas whose partial pressure is different from that of the source gas in the film forming step is supplied to the wafer 200. Thereby, in the etching step, the film forming amount by the source gas and the reactive gas can be set to be smaller than the etching amount by the source gas and the reactive gas. That is, the etching amount by the source gas and the reactive gas can be set to be larger than the film forming amount by the source gas and the reactive gas, and the etching can prevail. Therefore, in the present step, by supplying the source gas and the reactive gas under conditions where the etching prevails, it is possible to remove the nucleus formed on the wafer 200, and it is also possible to etch the film. That is, the halogen element contained in the source gas reacts with the reactive gas to generate the reaction by-products such as the HCl, the Cl₂ and hydrogen fluoride (HF). In the present embodiments, the reaction by-products may also be referred to as "halogen-containing by-products". By an action of the reaction by-products, since the nucleus formed on the wafer 200 is removed, it is possible to form the film on the wafer while maintaining the selectivity. In addition, as a mechanism of the etching, in addition to the etching by the reaction by-products described above, the etching by the source gas may also be considered. In addition, etching caused by by-products generated from the reaction (such as decomposition reaction) of the source gas is also conceivable. Although there are such various mechanisms of the etching, by controlling the supply amount of the source gas or by setting conditions such that the reaction by-products described above are easily generated, it is possible to set the conditions where the etching prevails.

In other words, in the etching step, the period in which the source gas is supplied overlaps with the period in which the reactive gas is supplied. According to the present embodiments, the supply of the source gas and the supply of the reactive gas are started simultaneously and stopped simultaneously. In addition, the supply time of the source gas in the present step is set to be shorter than the supply time of the source gas in the step S2. Thereby, it is possible to remove the nucleus formed in the film forming step. In addition, it is possible to adjust the supply time of the source gas in the present step depending on an etching rate.

### <Performing Predetermined Number of Times, Step S6>

By performing a cycle (wherein the steps S1 to S5 described above are performed sequentially) a predetermined number of times (m times, wherein m is an integer of 1 or 2 or more), it is possible to form a predetermined film of a predetermined thickness in the recess on the wafer 200. The predetermined film formed in the present step is a film free of the seam or the void, for example, the metal-containing film such as the molybdenum-containing film.

In addition, the number of times (n) in the step S4 described above is set to be equal to or greater than the number of times (m) in the step S6 described above. Preferably, the number of times (n) is set to be greater than the number of times (m). That is, the number of the executions of the cycle in the film forming step described above is set to be greater than the number of executions of the cycle in the etching step described above, and for example, one execution of the cycle in the etching step is performed for every two executions of the cycle in the film forming step. Thereby, it is possible to remove the nucleus grown in the film forming step while improving the film forming rate, and it is also possible to uniformly form the film while maintaining the selectivity. As a result, it is possible to improve the characteristics of the film formed as described above.

Specifically, after performing the step S4 in which the cycle of performing the steps S1 to S3 sequentially is performed the predetermined number of times (n times, wherein n is an integer of 1 or 2 or more), the step S5 described above is performed. Thereby, the nucleus as shown in FIG. 5(B) is removed as shown in FIG. 5(C). Then, by performing the step S6 in which the cycle of performing the steps S1 to S5 sequentially is performed the predetermined number of times (m times, wherein m is an integer of 1 or 2 or more), the metal-containing film 500 free of the seam or the void is formed uniformly in the recess on wafer 200 as shown in FIG. 5(D).

### <After-purge Step and Returning to Atmospheric Pressure Step>

Then, the inert gas is supplied into the process chamber 201 through each of the gas supply pipes 232c and 232d, and is exhausted through the exhaust pipe 231. The inert gas acts as a purge gas. Thereby, the inner atmosphere of the process chamber 201 is purged with the inert gas. As a result, a substance such as a gas remaining in the process chamber 201 and the reaction by-products remaining in the process chamber 201 is removed from the process chamber 201 (after-purge step). Thereafter, the inner atmosphere of the process chamber 201 is replaced with the inert gas (substitution by inert gas), and the inner pressure of the process chamber 201 is returned to a normal pressure (returning to atmospheric pressure step).

### <Wafer Discharging Step>

Thereafter, the seal cap 219 is lowered by the boat elevator 115 and the lower end of the manifold 209 is opened. Then, the boat 217 with the wafers 200 (which are processed therein) is unloaded (transferred) out of the reaction tube 203 through the lower end of the manifold 209 (boat unloading step). Then, the wafers 200 (which are processed) are discharged (transferred) from the boat 217 unloaded out of the reaction tube 203 (wafer discharging step).

### (3) Effects According to Present Embodiments

According to the present embodiments, it is possible to obtain one or more of the following effects.
(a) In the substrate processing, it is possible to adjust the film forming amount by the source gas and the reactive gas and the etching amount by the source gas and the reactive gas.
(b) Specifically, by adjusting the partial pressure of the source gas and the partial pressure of the reactive gas, the film forming amount by the source gas and the reactive gas can be set to be larger than the etching amount by the source gas and the reactive gas. Thereby, it is possible to form the film on the wafer 200.
(c) In addition, by adjusting the partial pressure of the source gas and the partial pressure of the reactive gas, the film forming amount by the source gas and the reactive gas can be set to be smaller than the etching amount by the source gas and the reactive gas. Thereby, it is possible to etch the film on the wafer 200. In other words, by the action of the reaction by-products, it is possible to remove the nucleus formed in the film forming step.
(d) In the film forming step and the etching step, by simultaneously supplying the source gas and the reactive gas, it is possible to improve the film forming rate.
(e) In the film forming step, by continuously supplying the reactive gas after the simultaneous supply of the source gas and the reactive gas, it is possible to remove the reaction by-products generated by the supply of the source gas and the supply of the reactive gas from the process chamber 201, and it is also possible to prevent (or suppress) the reaction by-products remaining in the process chamber 201 from being adsorbed on the wafer 200. In addition, it is possible to react the source gas (which is unreacted) with the reactive gas.
(f) In addition, in the film forming step, by setting the supply time of the reactive gas after the source gas is supplied to be longer than the supply time of the reactive gas before the source gas is supplied, while improving the efficiency of removing the reaction by-products, it is possible to react the source gas (which is unreacted) with the reactive gas. As a result, it is possible to improve the film forming rate.
(g) In a manner described above, by removing the nucleus formed in the film forming step while improving the film forming rate, it is possible to form the film on the wafer 200 uniformly while maintaining the selectivity. As a result, it is possible to improve the characteristics of the film formed on the wafer 200.

### (4) Other Embodiments

Subsequently, modified examples of the substrate processing and the substrate processing apparatus of the embodiments mentioned above will be described in detail. In the following description of the modified examples, features different from those of the embodiments mentioned above will be mainly described in detail.

### <First Modified Example>

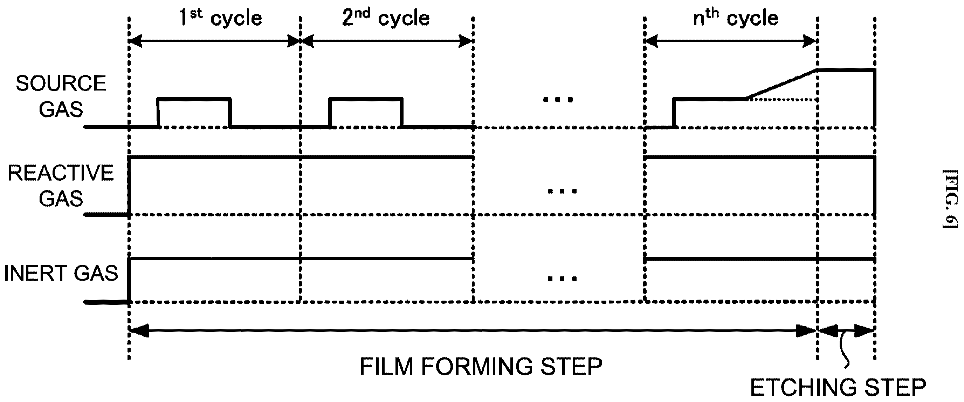

In the present modified example, as shown in FIG. 6, in an n^{th} execution of the cycle of performing the steps S1 to S3 sequentially in the step S4 mentioned above, after the simultaneous supply of the source gas and the reactive gas in the step S2 described above is performed, the simultaneous supply of the source gas and the reactive gas in the step S5 is consecutively performed. That is, in the n^{th} execution of the cycle of performing the steps S1 to S3 sequentially, the source gas is continuously supplied between the simultaneous supply of the source gas and the reactive gas in the step S2 and the simultaneous supply of the source gas and the reactive gas in the step S5. That is, in the n^{th} execution of the cycle of performing the steps S1 to S3 sequentially, the partial pressure of the source gas is continuously increased from the step S2 to the step S5. According to the present modified example, it is also possible to obtain substantially the same effects as the embodiments mentioned above. In addition, according to the present modified example, it is possible to further improve the film forming rate. In addition, the source gas which is continuously supplied is at least one among the first source gas and the second source gas. In FIG. 6, a case where n is 3 or more is shown. However, n may be 1 or more.

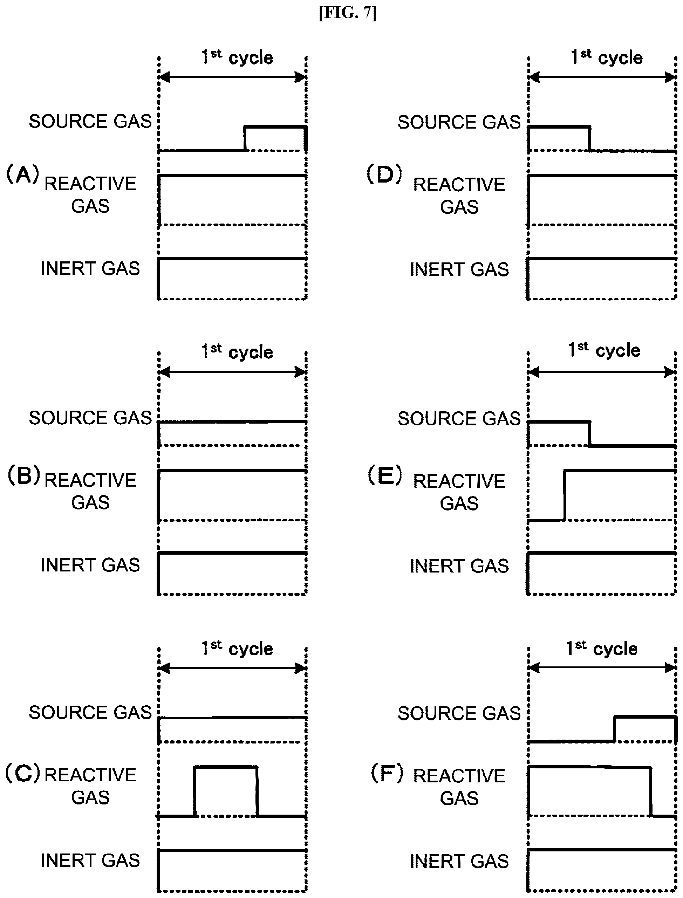

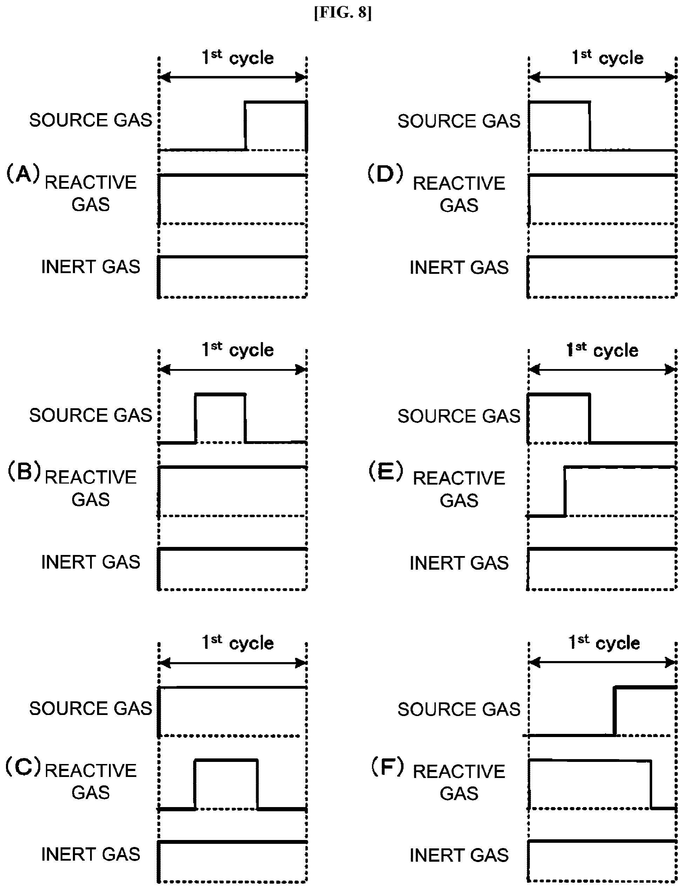

FIGS. 7(A) to 7(F) are diagrams schematically illustrating modified examples of the film forming step mentioned above, respectively, and FIGS. 8(A) to 8(F) are diagrams schematically illustrating modified examples of the etching mentioned above, respectively. In a second modified example to a seventh modified example described below, the source gas and the reactive gas are supplied under conditions where the film forming amount is set to be larger than the etching amount. In an eighth modified example to a thirteenth modified example described below, the source gas and the reactive gas are supplied under conditions where the etching amount is set to be larger than the film forming amount. Specifically, the partial pressure of the source gas in the etching step is set to be higher than the partial pressure of the source gas in the film forming step. In addition, the number of the executions of the cycle in the film forming step is set to be greater than the number of the executions of the cycle in the etching step, and the supply time of the source gas in the etching step is set to be shorter than the supply time of the source gas in the film forming step. Under the conditions mentioned above, the film forming step mentioned above (or the modified examples of the film forming step) and the etching step mentioned above (or the modified examples of the etching step) may be used in appropriate combination.

### <Second Modified Example>

In the present modified example, as shown in FIG. 7(A), in the cycle of the film forming step, the supply of the source gas is started after the supply of the reactive gas is started, and the supply of the source gas and the supply of the reactive gas are stopped simultaneously. In other words, in the cycle, there is a period during which the supply of the source gas and the supply of the reactive gas overlap with each other. In addition, the source gas is supplied such that the partial pressure of the source gas is set to be lower than the partial pressure of the reactive gas. According to the present modified example, it is also possible to obtain substantially the same effects as the embodiments mentioned above.

### <Third Modified Example>

In the present modified example, as shown in FIG. 7(B), in the cycle of the film forming step, the supply of the source gas and the supply of the reactive gas are started simultaneously and stopped simultaneously. In other words, in the cycle, the supply of the source gas and the supply of the reactive gas overlap. In addition, the source gas is supplied such that the partial pressure of the source gas is set to be lower than the partial pressure of the reactive gas. According to the present modified example, it is also possible to obtain substantially the same effects as the embodiments mentioned above.

### <Fourth Modified Example>

In the present modified example, as shown in FIG. 7(C), in the cycle of the film forming step, the supply of the reactive gas is started after the supply of the source gas is started, and the supply of the reactive gas is stopped while the source gas is supplied. In other words, in the cycle, there is a period during which the supply of the source gas and the supply of the reactive gas overlap with each other. In addition, the source gas is supplied such that the partial pressure of the source gas is set to be lower than the partial pressure of the reactive gas. According to the present modified example, it is also possible to obtain substantially the same effects as the embodiments mentioned above.

### <Fifth Modified Example>

In the present modified example, as shown in FIG. 7(D), in the cycle of the film forming step, the supply of the source gas and the supply of the reactive gas are started simultaneously, and the supply of the source gas is stopped while the reactive gas is supplied. In other words, in the cycle, there is a period during which the supply of the source gas and the supply of the reactive gas overlap with each other. In addition, the source gas is supplied such that the partial pressure of the source gas is set to be lower than the partial pressure of the reactive gas. According to the present modified example, it is also possible to obtain substantially the same effects as the embodiments mentioned above.

### <Sixth Modified Example>

In the present modified example, as shown in FIG. 7(E), in the cycle of the film forming step, the supply of the reactive gas is started after the supply of the source gas is started, and the supply of the source gas is stopped while the reactive gas is supplied. In other words, in the cycle, there is a period during which the supply of the source gas and the supply of the reactive gas overlap with each other. In addition, the source gas is supplied such that the partial pressure of the source gas is set to be lower than the partial pressure of the reactive gas. According to the present modified example, it is also possible to obtain substantially the same effects as the embodiments mentioned above.

### <Seventh Modified Example>

In the present modified example, as shown in FIG. 7(F), in the cycle of the film forming step, the supply of the source gas is started after the supply of the reactive gas is started, and the supply of the reactive gas is stopped while the source gas is supplied. In other words, in the cycle, there is a period during which the supply of the source gas and the supply of the reactive gas overlap with each other. In addition, the source gas is supplied such that the partial pressure of the source gas is set to be lower than the partial pressure of the reactive gas. According to the present modified example, it is also possible to obtain substantially the same effects as the embodiments mentioned above.

### <Eighth Modified Example>

In the present modified example, as shown in FIG. 8(A), in the cycle of the etching step, the supply of the source gas is started after the supply of the reactive gas is started, and the supply of the source gas and the supply of the reactive gas are stopped simultaneously. In other words, in the cycle, there is a period during which the supply of the source gas and the supply of the reactive gas overlap with each other. According to the present modified example, it is also possible to obtain substantially the same effects as the embodiments mentioned above.

### <Ninth Modified Example>

In the present modified example, as shown in FIG. 8(B), in the cycle of the etching step, the supply of the source gas is started after the supply of the reactive gas is started, and the supply of the source gas is stopped while the reactive gas is supplied. In other words, in the cycle, there is a period during which the supply of the source gas and the supply of the reactive gas overlap with each other. According to the present modified example, it is also possible to obtain substantially the same effects as the embodiments mentioned above.

### <Tenth Modified Example>

In the present modified example, as shown in FIG. 8(C), in the cycle of the etching step, the supply of the reactive gas is started after the supply of the source gas is started, and the supply of the reactive gas is stopped while the source gas is supplied. In other words, in the cycle, there is a period during which the supply of the source gas and the supply of the reactive gas overlap. According to the present modified example, it is also possible to obtain substantially the same effects as the embodiments mentioned above.

### <Eleventh Modified Example>

In the present modified example, as shown in FIG. 8(D), in the cycle of the etching step, the supply of the source gas and the supply of the reactive gas are started simultaneously, and the supply of the source gas is stopped while the reactive gas is supplied. In other words, in the cycle, there is a period during which the supply of the source gas and the supply of the reactive gas overlap. According to the present modified example, it is also possible to obtain substantially the same effects as the embodiments mentioned above.

### <Twelfth Modified Example>

In the present modified example, as shown in FIG. 8(E), in the cycle of the etching step, the supply of the reactive gas is started after the supply of the source gas is started, and the supply of the source gas is stopped while the reactive gas is supplied. In other words, in the cycle, there is a period during which the supply of the source gas and the supply of the reactive gas overlap. According to the present modified example, it is also possible to obtain substantially the same effects as the embodiments mentioned above.

### <Thirteenth Modified Example>

In the present modified example, as shown in FIG. 8(F), in the cycle of the etching step, the supply of the source gas is started after the supply of the reactive gas is started, and the supply of the reactive gas is stopped while the source gas is supplied. In other words, in the cycle, there is a period during which the supply of the source gas and the supply of the reactive gas overlap. According to the present modified example, it is also possible to obtain substantially the same effects as the embodiments mentioned above.

### <Fourteenth Modified Example>

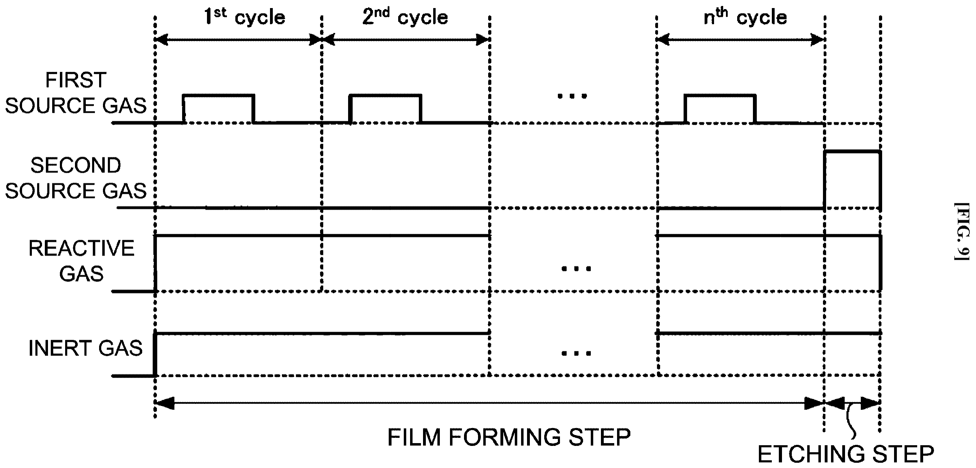

In the present modified example, as shown in FIG. 9, different source gases containing the halogen element are used in the film forming step and the etching step. That is, as the source gas, the first source gas and the second source gas are used. As the source gas supplier, a first source gas supplier (which is a first source gas supply system) through which the first source gas is supplied and a second source gas supplier (which is a second source gas supply system) through which the second source gas is supplied are used. In addition, the first source gas means the source gas used in the film forming step, and the second source gas means the source gas used in the etching step. In FIG. 9, a case where n is 3 or more is shown. However, n may be 1 or more.

Specifically, in the film forming step, the first source gas containing the halogen element and the metal element is used as the source gas. In the etching step, the second source gas containing the same halogen element and the metal element as the first source gas is used as the source gas. However, the number of the halogen element in one molecule of the second source gas is greater than the number of the halogen element in one molecule of the first source gas.

As shown in FIG. 9, in the step S2 mentioned above, the first source gas and the reactive gas are supplied simultaneously, and in the step S5 mentioned above, the second source gas and the reactive gas are supplied simultaneously. In addition, between a simultaneous supply of the first source gas and the reactive gas in the step S2 mentioned above and a simultaneous supply of the second source gas and the reactive gas in step S5 mentioned later, the reactive gas is continuously supplied without supplying either the first source gas or the second source gas.

As the first source gas, for example, the MoO₂Cl₂ gas, the MoO₂F₂ gas, the WCl₃ gas, the SiCl₄ gas, the DCS gas, the TiCl₄ gas, the AlCl₃ gas, the HfCl₄ gas and the ZrCl₄ gas may be used. As the first source gas, one or more of the gases exemplified above may be used.

As the second source gas, a source gas containing a larger number of the halogen element in one molecule than the first source gas, for example, a gas such as the MoCl₅ gas, the WF₆ gas, the WCl₆ gas, the MoOCl₄ gas, the MoOF₄ gas, the MoF₆ gas, and the HCDS gas may be used.

According to the present modified example, it is also possible to obtain substantially the same effects as the embodiments mentioned above. In addition, according to the present modified example, in the etching step, by using the second source gas containing a larger number of the halogen element in one molecule than the first source gas used in the film forming step, it is possible to increase the etching amount in the etching step, and it is also possible to further obtain an etching action.

### <Fifteenth Modified Example>

In addition, the substrate processing mentioned above is described by way of an example in which the film forming step and the etching step are performed successively (continuously). However, the technique of the present disclosure is not limited thereto. For example, a purge step of purging the gas remaining in the process chamber 201 may be provided between the film forming step mentioned above and the etching step mentioned above. In other words, between the film forming step mentioned above and the etching step mentioned above, the supply of the source gas and the supply of the reactive gas may be stopped, and a purge may be performed to remove the inner atmosphere of the process chamber 201. Specifically, after performing the film forming step the predetermined number of times, the valves 243a and 243b are closed to stop the supply of the source gas and the supply of the reactive gas into the process chamber 201. Then, by vacuum-exhausting the process chamber 201, it is possible to remove the gas remaining in the process chamber 201 (purge). At this time, the valves 243c and 243d are opened to supply the inert gas into the process chamber 201. The inert gas acts as the purge gas. According to the present modified example, it is also possible to obtain substantially the same effects as the embodiments mentioned above. In addition, according to the present modified example, before the etching step is performed, it is possible to remove the reaction by-products generated by the supply of the source gas and the supply of the reactive gas from the process chamber 201, and it is also possible to prevent (or suppress) the reaction by-products remaining in the process chamber 201 from being adsorbed on the wafer 200.

### <Sixteenth Modified Example>

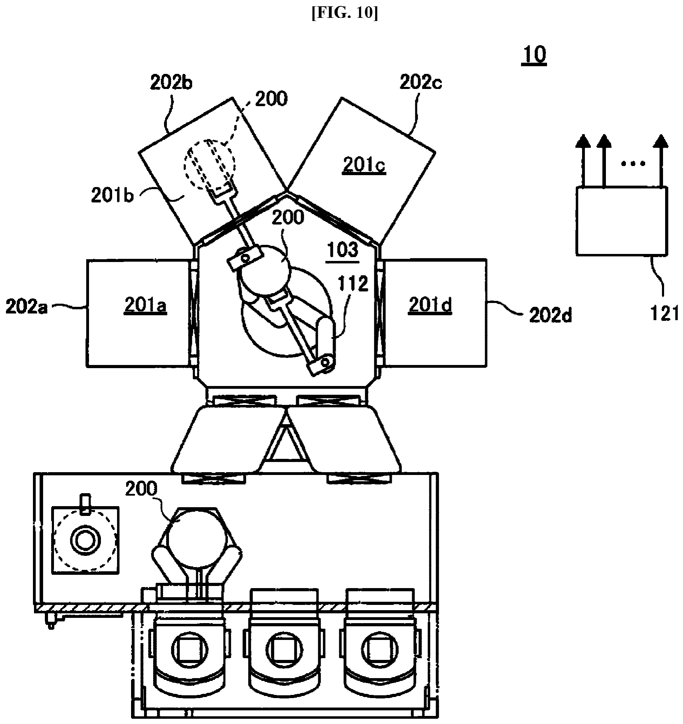

In the present modified example, as shown in FIG. 10, a cluster-type substrate processing apparatus 10 provided with a plurality of process furnaces 202a to 202d is used, wherein the plurality of process furnaces 202a to 202d are connected to a vacuum transfer chamber 103 in which a substrate transfer apparatus 112 is installed.

According to the present modified example, the controller 121 is configured to perform the film forming step mentioned above and the etching step mentioned above separately in different process chambers of different process furnaces. In such a case, when the wafer 200 is transferred from a process chamber in which the film forming step is performed to another process chamber in which the etching step is performed, the wafer 200 is transferred under a vacuum atmosphere or an inert gas atmosphere. That is, the substrate processing apparatus 10 performs the film forming step in which the first source gas and the reactive gas are supplied, and the etching step in which the second source gas and the reactive gas are supplied, separately in different process chambers. According to the present modified example, it is also possible to obtain substantially the same effects as the embodiments mentioned above. In addition, it is preferable to use the present modified example when the source gas in the film forming step and the source gas in the etching step are different.

For example, the metal-containing film of the present disclosure is a film containing at least one element among the Group 3 element to the Group 13 element and silicon element. Preferably, the metal-containing film is a film containing at least one element among the Group 3 element to the Group 13 element. More preferably, the metal-containing film is a film containing the transition metal. The metal-containing film is at least one among a film of a metal element alone containing a metal element as a main component, a metal oxide film, a metal nitride film, a metal carbide film, a metal oxynitride film, a metal carbonitride film and a metal oxycarbide film. Preferably, the metal-containing film 300 of the present disclosure is a metal nitride film. In addition, the metal-containing film 500 is a film of a metal element alone containing a metal element as a main component. For example, the metal-containing film 500 is a film of a metal element alone containing at least one among Ti, Zr, Hf, V, Nb, Ta, Mo, W, Ni, Zn, Al, Ga, In and Si as a main component. In addition, for example, as the metal-containing film 300, the following films may be used: a film such as a lanthanoid nitride film, a TiN film, a ZrN film, a HfN film, a VN film, a NbN film, a TaN film, a MoN film, a WN film, an AlN film, a GaN film and an InN film.

For example, the embodiments mentioned above are described by way of an example in which a batch type substrate processing apparatus capable of simultaneously processing a plurality of substrates is used to form the film is used to form the film. However, the technique of the present disclosure is not limited thereto. For example, the technique of the present disclosure may be preferably applied when a single wafer type substrate processing apparatus capable of processing one or several substrates at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process sequence mentioned above may be performed consecutively in the same process chamber (process vessel) (in-situ). Alternatively, for example, at least one among the processes in the process sequence mentioned above and another process may be performed in different process chambers (process vessels) (ex-situ). In either case, it is possible to obtain substantially the same effects as in the embodiments or the modified examples mentioned above. In addition, when the processes are performed in-situ, it is possible to suppress a contamination of the substrate and a change in a surface state of the substrate which may occur when the substrate is unloaded out of the process chamber or loaded into the process chamber between the processes. In addition, when the processes are performed in-situ, it is possible to shorten a transition time between the processes. On the other hand, when the processes are performed ex-situ, since the processes can be performed in parallel in different process chambers, it is possible to increase the productivity.

Process procedures and process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

In addition, the embodiments and the modified examples mentioned above may be appropriately combined. The process procedures and the process conditions of each combination thereof may be substantially the same as those of the embodiments mentioned above or the modified examples mentioned above.

While the technique of the present disclosure is described in detail by way of the embodiments and the modified examples mentioned above, the technique of the present disclosure is not limited thereto. The technique of the present disclosure may be modified in various ways without departing from the scope thereof.

### [Description of Reference Numerals]

- 200: Wafer (Substrate)

## Claims

1. A substrate processing method comprising:
(a) forming a film by supplying a first source gas and a reactive gas to a substrate; and
(b) etching the substrate by supplying a second source gas and the reactive gas to the substrate after (a).

2. The substrate processing method of claim 1, wherein the first source gas and the reactive gas are supplied in (a) such that a film forming amount becomes larger than an etching amount, and the second source gas and the reactive gas are supplied in (b) such that the film forming amount becomes smaller than the etching amount.

3. The substrate processing method of claim 2, wherein a partial pressure of the first source gas in (a) is different from a partial pressure of the second source gas in (b).

4. The substrate processing method of claim 3, wherein the partial pressure of the second source gas in (b) is higher than the partial pressure of the first source gas in (a).

5. The substrate processing method of claim 1, wherein the first source gas and the second source gas comprise gases containing a halogen element, respectively.

6. The substrate processing method of claim 5, wherein the first source gas and the second source gas comprise gases containing a metal element, respectively.

7. The substrate processing method of claim 1, wherein the reactive gas comprises a reducing gas.

8. The substrate processing method of claim 7, wherein the reactive gas comprises a gas containing hydrogen.

9. The substrate processing method of claim 1, wherein the reactive gas is continuously supplied between (a) and (b).

10. The substrate processing method of claim 1 or 9, wherein neither the first source gas nor the second source gas is supplied between (a) and (b).

11. The substrate processing method of claim 1, further comprising
continuously supplying at least one of the first source gas or the second source gas between (a) and (b).

12. The substrate processing method of claim 1, wherein, in (a), a period in which the first source gas is supplied overlaps with a period in which the reactive gas is supplied.

13. The substrate processing method of claim 1 or 12, wherein, in (b), a period in which the second source gas is supplied overlaps with a period in which the reactive gas is supplied.

14. The substrate processing method of claim 1, wherein, in (a), the first source gas is supplied while the reactive gas is being supplied.

15. The substrate processing method of claim 13, wherein, in (a), the reactive gas is continuously supplied before and after the first source gas is supplied.

16. The substrate processing method of claim 14, wherein, in (a), a supply time of the reactive gas after the first source gas is supplied is set to be longer than a supply time of the reactive gas before the first source gas is supplied.

17. The substrate processing method of claim 1, wherein a supply time of the second source gas in (b) is set to be shorter than a supply time of the first source gas in (a).

18. The substrate processing method of claim 11, wherein (a) and (b) are each performed a predetermined number of times, and number of executions of (a) is set to be greater than number of executions of (b).

19. The substrate processing method of claim 1, wherein the first source gas and the second source gas are the same source gas.

20. The substrate processing method of claim 1, wherein the first source gas and the second source gas are different source gases.

21. The substrate processing method of claim 1, wherein number of halogen element in one molecule of the second source gas used in (b) is set to be greater than number of halogen element in one molecule of the first source gas used in (a).

22. A method of manufacturing a semiconductor device comprising:
(a) forming a film by supplying a first source gas and a reactive gas to a substrate; and
(b) etching the substrate by supplying a second source gas and the reactive gas to the substrate after (a).

23. A program that causes, by a computer, a substrate processing apparatus to perform:
(a) forming a film by supplying a first source gas and a reactive gas to a substrate; and
(b) etching the substrate by supplying a second source gas and the reactive gas to the substrate after (a).

24. A substrate processing apparatus comprising:
a gas supplier configured to be capable of supplying each of a first source gas, a second source gas and a reactive gas to a substrate; and
a controller configured to be capable of controlling the gas supplier to perform:
(a) forming a film by supplying the first source gas and the reactive gas to the substrate; and
(b) etching the substrate by supplying the second source gas and the reactive gas to the substrate after (a).
